# EUROPÄISCHE PATENTSCHRIFT

(11) **EP 0 482 229 B1**
(45) Veröffentlichungstag und Bekanntmachung des Hinweises auf die Patenterteilung: **10.08.1994**
(21) Anmeldenummer: 90120260.6
(22) Anmeldetag: 22.10.1990
(51) Int. Cl.: G01R 31/12, G01R 31/34

(54) **Einrichtung zur Erfassung von Teilentladungen an Wicklungselementen einer elektrischen Maschine**
Device for monitoring partial discharges in winding elements of an electric machine
Dispositif pour déterminer des décharges partielles d'enroulement d'une machine électrique

(43) Veröffentlichungstag der Anmeldung: 29.04.1992
(73) Patentinhaber: ASEA BROWN BOVERI AG, 5400 Baden (CH)
(72) Erfinder: Brühlmeier, Paul, CH-5430 Wettingen (CH); Fuhr, Jitka, Dr., CH-8600 Dübendorf (CH); Kohler, René, CH-5116 Schinznach-Bad (CH); Kopp, Albert, CH-5200 Windisch (CH); Hässig, Martin, CH-8153 Rümlang (CH)

(56) Entgegenhaltungen:
- GB-A- 2 195 771
- US-A- 2 890 407
- US-A- 4 949 001

## Beschreibung

Die Erfindung bezieht sich auf eine Einrichtung zur Erfassung von Teilentladungen in Wicklungselementen einer elektrischen Maschine, bei welcher das zu untersuchende Wicklungselement bei angelegter Hochspannung mittels einer auf einem Träger angeordnetem fahrbaren Sonde über seine Länge abgetastet und die durch die Teilentladungen initiierten Hochfrequenz-Signale mittels einer Antenne empfangen und in einem nachgeschalteten Messgerät erfasst und ausgewertet werden.

Ausgangspunkt für die Erfindung ist ein Stand der Technik, wie er sich beispielsweise aus dem CIGRE-Bericht "Diagnostics of HV Machine Insulation - From Inspection to Continuous Monitoring" von A.Kelen, CIGRE-Symposium 05-87, Wien 1987, S.1020-05, ergibt.

### Technologischer Hintergrund und Stand der Technik

Die elektrischen Isolationssysteme der Statorwicklungen in rotierenden elektrischen Maschinen unterliegen Alterungsprozessen, die hauptsächlich durch mechanische, thermische und elektrische Beanspruchungen verursacht werden. Diese Beanspruchungen erzeugen in den beteiligten Isoliermaterialien Schwachstellen, in denen bei Betriebsbeanspruchung gefährliche Teilentladungen (TE) entstehen. Die sogenannten Nutentladungen sind die meistgefürchteten TE-Phänomene im Maschinen-Isolationssystem. Durch eine frühzeitige Detektion und Lokalisierung der Nutentladungen werden zum einen die Energieerzeuger und Verbraucher vor unkontrollierten Ausfällen in Energieversorgungsnetzen bewahrt, zum anderen wird die Zerstörung der Isolation verhindert, da die meisten früh entdeckten Defekte reparierbar sind.

Im eingangs zitierten CIGRE-Bericht vermittelt der Autor einen umfassenden Ueberblick über die derzeit bekannten Messverfahren und Einrichtungen zur Erfassung von Teilentladungen. Der Bericht beschränkt sich jedoch auf eine eher summarische Darstellung der bislang verwendeten Verfahren und Geräte. Eine mehr ins Detail gehende Arbeit über Teilentladungen und deren Diagnose sowie die Interpretation der Messergebnisse ist im CIGRE-Papier 15/33-12, B.Fruth, J.Fuhr "Partial Discharge Pattern Recognition - A Tool for Diagnosis and Monitoring of Aging", veröffentlicht, verteilt an der CI-GRE 1990 Session, 26.August - 1.September 1990.

Teilentladungen entstehen nur bei einer ausreichenden elektrischen Beanspruchung (Nennspannung) der Isolation. Um eine Nutentladung eindeutig identifizieren zu können, ist es notwendig, bei angelegter Hochspannung an der Statorwicklung zu arbeiten. Dies ist aber mit einer Gefährdung des Testpersonen verbunden und erfordert in der Regel den Ausbau des Rotors.

### Kurze Darstellung der Erfindung

Ausgehend vom Stand der Technik liegt der Erfindung die Aufgabe zugrunde, eine Einrichtung zur Erfassung von Teilentladungen anzugeben, die bei angelegter Hochspannung ohne Gefährdung des Bedienungspersonals eine Detektion und Lokalisierung von Teilentladungen ermöglicht.

Die Lösung dieser Aufgabe erfolgt erfindungsgemäss dadurch, dass der Träger mittels Zugseilen, einer Spindelstange oder eines Zugbandes oder mit Eigenantrieb versehen, ferngesteuert in Maschinenlängsrichtung verfahrbar ist.

Die Grösse des Maschinenluftspalts sowie die Lage der Maschinenachse bestimmen dabei in erster Linie, welcher der beiden Alternativen eingesetzt wird. Die Lösung mit Seilzügen bzw. Spindelstangen eignet sich insbesondere für grosse Turbogeneratoren mit beträchtlicher Länge des Luftspalts. Bei Hydrogeneratoren, welche in der Regel einen vergleichsweise kleinen Luftspalt aufweisen, sowie für Maschinen mit vertikaler Achse wird die Variante mit Zugbändern bevorzugt. Beide Varianten zeichnen sich durch hohe Wirtschaftlichkeit aus, weil das zeitraubende Ausbauen des Rotors entfällt.
Ist der Rotor zu Reparatur- oder Servicezwecken ohnehin entfernt, wird man der Variante mit Eigenantrieb den Vorzug geben.
Vorzugsweise führen bei einer ersten Weiterbildung der Erfindung die Zugseile oder Zugstangen an beiden Rotorseiten an Sondensupporte. Diese sind an einem bezüglich der Rotorachse rotationssysmmetrischen Maschinenteil, vorzugsweise dem Maschinenlüfter oder einer geeigneten Hilfsvorrichtung, in Umfangsrichtung verschiebbar befestigt. Insbesondere bei Radiallüftern ergibt sich auf diese Weise eine einfache Befestigung der Sondensupporte. Bei Axiallüftern dient eine Hilfsvorrichtung, welche auf den Aussenumfang oder dem Ventilatorträger (Nabe) des Axialventilators aufgesetzt wird, der Befestigung der Sondensupporte. Bei Hydromaschinen mit vertikaler Achse ist die Variante mit Spindelstangen oder Zugbändern und mit nur einem einzigen Sondensupport vorteilhaft, weil bei derartigen Maschinen die Maschinenunterseite weniger gut zugänglich ist.

Die Sonde selbst weist mindestens eine AM-Antenne auf. Das Antennensignal wird entweder (unverstärkt) dem Messgerät ausserhalb der Maschine zugeführt, oder die Sonde enthält einen Antennensignal-Verstärker, oder die Sonde enthält einen vollständigen AM-Empfänger in Miniaturausführung, in welchem das empfangene Signal demoduliert wird und als NF-Signal dem Messgerät zugeführt wird.

Die Erfindung wird nachstehend anhand der Zeichnung näher erläutert.

### Kurze Beschreibung der Zeichnung

In der Zeichnung zeigt
- Fig. 1: eine schematische Darstellung der Einrichtung zur Erfassung von Teilentladungen, teilweise in Blockdarstellung;
- Fig. 2: eine Ansicht einer im Luftspalt eines Turbogenerators mittels Seilzügen verfahrbaren Sonde;
- Fig. 3: eine Ansicht auf einen von zwei Sondensupporten am Maschinenende, die auf dem Maschinenlüfter befestigt sind;
- Fig. 4: einen Schnitt durch den Sondensupport gemäss Fig.3 mit einem als Radiallüfter ausgebildeten Maschinenlüfter;
- Fig. 5: einen Schnitt durch den Sondensupport gemäss Fig.4 längs deren Linie AA;
- Fig.6: eine Draufsicht auf die Stirnseite eines Turbogenerator-Rotors mit einem Axiallüfter, auf dessen Aussenumfang eine Hilfsvorrichtung zur Aufnahme des Sondensupports befestigt ist;
- Fig.7: einen Schnitt durch einen Sondensupport für Sonden, welche mittels einer Spindelstange und geführt von zwei Spurstangen im Luftspalt verfahrbar ist;
- Fig.8: eine Draufsicht auf einen Sondensupport für Sonden, welche mittels eines Zugbandes im Luftspalt verfahrbar sind;
- Fig.9: eine Draufsicht auf eine Sonde mit Eigenantrieb;
- Fig.10: eine Seitenansicht einer Sonde mit Eigenantrieb gemäss Fig.9.

### Detaillierte Beschreibung der Erfindung

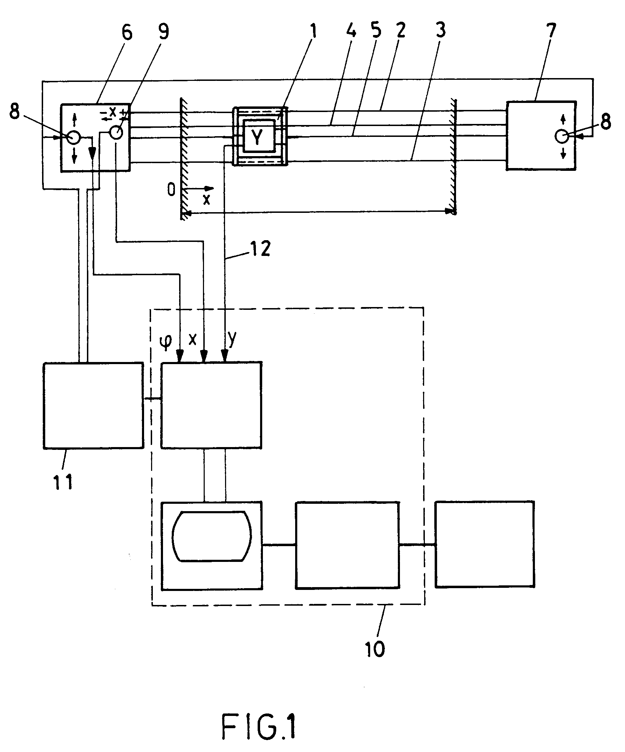

Die Einrichtung zur Erfassung von Teilentladungen gemäss Fig.1 ist aus Gründen der Uebersichtlichkeit teilweise in Blockdarstellung verdeutlicht. Eine Sonde 1 ist an Tragseilen 2,3 im Luftspalt einer grossen elektrischen Maschine in deren Längsrichtung mittels Zugseilen 4,5 verfahrbar. Zug- und Tragseile sind zwecks Potentialtrennung und aus Sicherheitsgründen isoliert. Sie führen beidseits der Maschine und ausserhalb des Luftspalts zu je einem Sondensupport 6,7. Beide Sondensupporte 6,7 weisen eine Antriebsvorrichtung 8 auf zum Verfahren der Sondensupporte 6,7 und damit der Sonde 1 selbst in Umfangsrichtung. Der linke Sondensupport 6 umfasst darüber hinaus eine Antriebsvorrichtung 9 für die Zugseile 4,5, um die Sonde 1 in Maschinenlängsrichtung durch den Luftspalt bewegen zu können. Sämtliche Antriebsvorrichtungen 8 und 9 sind mit an sich bekannten Drehgebern gekoppelt, welche ein dem von den Sonde 1 zurückgelegten Weg x in Maschinenlängsrichtung und Winkel Φ in Umfangsrichtung entsprechendes Signal an ein Messgerät 10 liefern. Dem Messgerät 10 wird ferner das Ausgangssignal der Sonde 1 selbst (Signal y) zugeführt. Die Steuerung der Antriebsvorrichtungen 8 und 9 erfolgt über eine Steuereinrichtung 11.

Die Sonde 1 ist über ein abgeschirmtes Kabel 12 mit dem Messgerät 10 verbunden. Sie enthält im einfachsten Fall eine Antenne zum Empfang amplitudenmodulierter HF-Signale. Sie kann daneben auch einen Verstärker für derartige HF-Signale aufweisen. Endlich kann die Sonde 1 mit einem kompletten AM-Empfänger mit Demodulator ausgerüstet sein, an dessen Ausgang ein demoduliertes NF-Signal ansteht. Je nach Aufbau der Sonde 1 ist demgemäss auch das Messgerät 10 ausgerüstet, wobei diese Ausrüstung sich nach der Bestückung der Sonde 1 richtet.
Bei einer lediglich mit einer AM-Antenne ausgerüsteten Sonde wird das dem Messgerät 10 zugeführte AM-Signal verstärkt und demoduliert. Nach der Weiterverarbeitung (Verstärkung) im Messgerät wird das Signal im einfachsten Fall an den Y-Eingang eines XY-Schreibers geführt, während das den Weg der Sonde in Maschinenlängsrichtung repäsentierende X-Signal an den X-Eingang des Schreibers gelegt wird. In einer aufwendigeren Ausführung wird das Signal im Messgerät 10 digitalisiert und einer elektronischen Datenverarbeitungeinheit, in der ebenfalls XY-Graphiken ausgegebene werden, zugeführt. Ist in die Sonde bereits ein HF-Verstärker integriert, kann das Hf-Signal im Messgerät 10 direkt einem Demodulator zugeführt werden. Bei einer mit einem AM-Empfänger und Demodulator versehenen Sonde kann das niederfrequente Eingangssignal direkt im Messgerät 10 weiterverarbeitet werden.
Wird die Sonde 1 bei an der Statorwicklung der Maschine anliegenden Nennspannung durch den Luftspalt bewegt, empfängt die Antenne amplitudenmodulierte HF-Signale. Bei Isolationsdefekten oder Isolationsschwachstellen ist das Antennensignal an diesen Stellen charakteristisch verändert. Somit lässt sich aus dem auf diese Weise aufgezeichneten Diagramm in eindeutiger Weise auf den Isolationszustand der Statorwicklung schliessen.

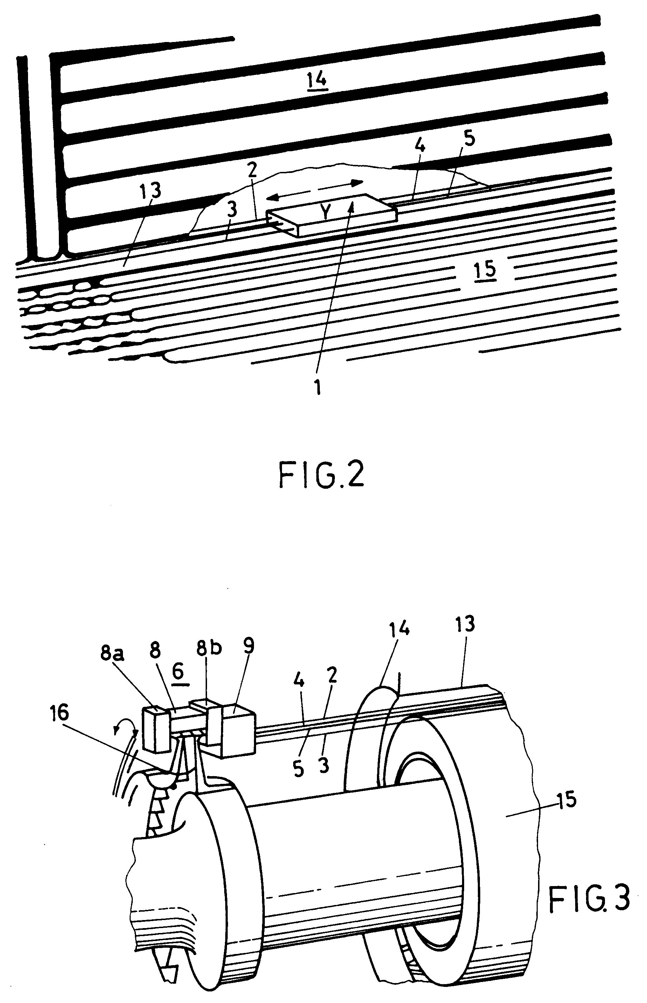

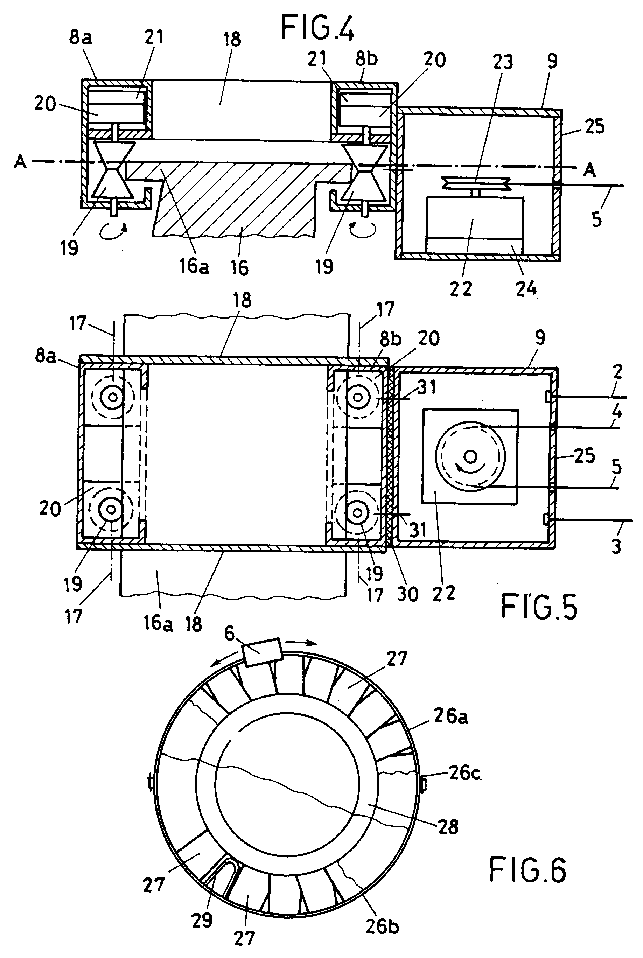

Fig.2 vermittelt in perspektivischer Darstellung einen Ausschnitt aus einem Turbogenerator. Im Luftspalt 13 zwischen Stator 14 und Rotor 15 ist die an den Tragseilen 2, 3 geführte und von den Zugseilen 4, 5 bewegbare Sonde 1 sichtbar. Fig.3 vermittelt die Anordnung des am Aussenumfang des Radialventilator 16 des Rotors befestigten linken Sondensupports 6. Der Sondensupport 6 ist modular aufgebaut und umfasst die Antriebsvorrichtung 8 zur Bewegung der Sonde 1 in Umfangsrichtung und die Antriebsvorrichtung 9 für die Bewegung der Sonde 1 in Maschinenlängsrichtung. Ein mehr ins Detail gehendes Bild des Sondensupports vermitteln die Figuren 4 und 5.

In zwei mittels Verbindungsplatten 18 und Schrauben 17 zusammengehaltenen Rollenträgern 8a und 8b sind je zwei Antriebsrollen 19 drehbar gelagert. Sie werden je von einem Motor 20 mit angebautem oder integriertem Drehgeber 21 angetrieben. Die Antriebsrollen 19 wirken mit dem Aussenring 16a des Radialventilators 16 zusammen; der Aussenring 16a des Radialventilators 16 dient dabei auch als Führungsbahn für den Sondensupport 6. Die demontierbaren Trägerplatten 18 ermöglichen es, den Sondensupport 6 auf dem Aussenring 16a des Radialventilators 16 aufzusetzen.
An der dem Maschineninneren zugewandten Fläche der Antriebsvorrichtung 8 ist die Antriebsvorrichtung 9 angebracht. Diese umfasst einen Antriebsmotor 22 mit Seilrolle 23 und integriertem oder angebautem Drehgeber 24 für die Bewegung der Sonde 1 in Maschinenlängsrichtung. An der maschinenseitigen Stirnwand 25 der Antriebsvorrichtung 9 sind die beiden Tragseile 2, 3 verankert. In Fig.5 ist (abweichend von Fig.4) eine Möglichkeit der Potentialtrennung zwischen Sonde 1 und Sondensupport 6 angedeutet. Die Antriebsvorrichtung 9 ist unter Zwischenschaltung einer Platte 30 mittels Schrauben 31 aus Isoliermaterial an der Antriebsvorrichtung 8 befestigt.

Bei Maschinen mit Axiallüfter(n) ist a priori keine Verankerungsmöglichkeit/Führungsbahn für die Sondensupporte 6,7 vorhanden. Hier lässt sich jedoch gemäss Fig.6 eine Hilfsvorrichtung in Form eines zwei- oder mehrteiligen Rings 26a, 26b, der mittels Schrauben 26c zusammengespannt ist, einsetzen. Eine weitere Möglichkeit bietet sich bei Maschinen mit Axiallüfter dort an, wo einzelne oder alle Schaufeln 27 ohne Aufwand abnehmbar sind, weil sie z.B. mit der Nabe 28 des Lüfters verschraubt sind (vgl. untere Hälfte der Fig.6). Dort wird ein gleichfalls zwei- oder mehrteiliger Ring mit den Ringhälften 21a und 21b mit einem oder mehreren nach innen gerichteten Befestigungsteil 29 an die Stelle der entfernten Schaufeln angebracht.

Bei Maschinen mit nur einem Lüfter - sei es einer axialer oder auch radialer Bauart - ist es in aller Regel notwendig, auf der Maschinenseite ohne Lüfter eine rotationssymmetrische Hilfskonstruktion anzubringen, um die Tragseile 2,3 zu verankern und die Umlenkrolle für das Zugseil zu fixieren. Dies lässt sich jedoch mit einer Hilfsvorrichtung erzielen, welche mit derjenigen gemäss Fig.6, untere Hälfte, vergleichbar ist. Eine solche Hilfsvorrichtung kann dabei auf die Welle aufgespannt werden.

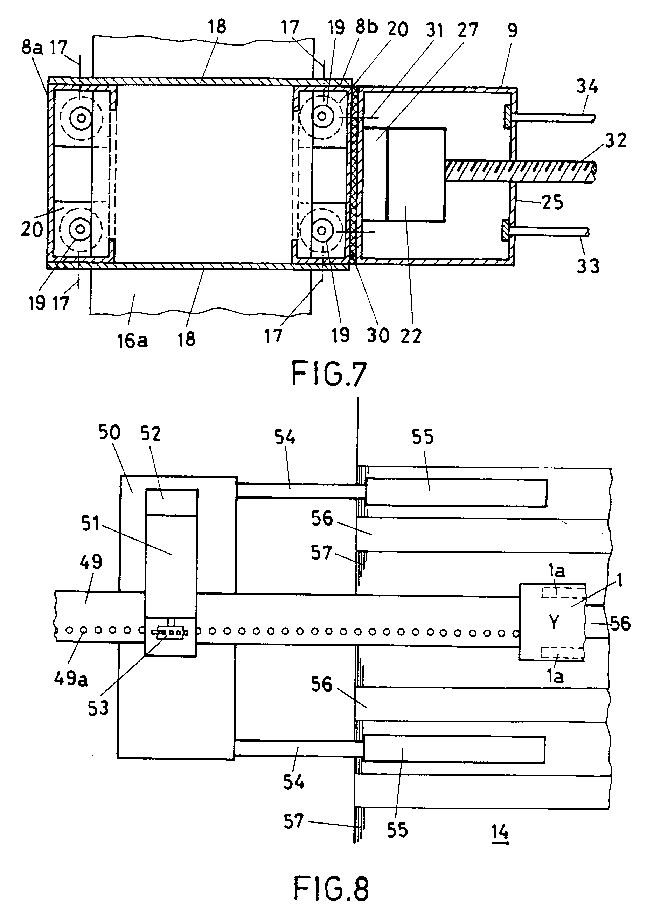

Bei vertikalachsigen elektrischen Maschinen ist oft die Unterseite der Maschine nicht ohne weiteres zugänglich. Um auch bei solchen Maschinen Teilentladungen bei angelegter Stator-Nennspannung erfassen zu können, ist eine Modifikation des Sondenantriebes zweckmässig, wie sie in Fig.7 schematisch dargestellt ist. Die Antriebsvorrichtung 8 für die Fortbewegung in Umfangsrichtung entspricht derjenigen nach Fig.5. Die Antriebsvorrichtung 9 für die Fortbewegung der Sonde 1 in Maschinenlängsrichtung umfasst einen mit einer Spindelstange 32 gekuppelten Antriebsmotor 22 mit integriertem oder angebautem Drehgeber 24. Zwei seitlich an der Stirnwand 25 verankerte Spurstangen 33, 34 verhindern ein Mitdrehen der Sonde 1. Letztere weist eine fest mit ihrem Träger verbundene Spindelmutter (nicht eingezeichnet) auf. Selbstverständlich eignet sich eine Konstruktion gemäss Fig.7 auch für andere Maschinentypen, insbesondere für solche mit kurzen Eisenlängen.

Für vertikalachsige Maschinen sowie für horizontalachsige Maschinen mit kurzen Eisenlängen wird vorzugsweise eine Variante des Sondenantriebs eingesetzt, wie sie in Fig.8 dargestellt ist. Die Sonde 1 ist am Ende eines in Maschinenlängsrichtung verlaufenden Lochbandes 49 Isoliermatrial befestigt und lässt sich mittels diesem Lochband in Maschinenlängsrichtung verfahren. Der Sondensupport 50, welcher wie bei den vorangegangenen Ausführungsbeispielen die Antriebsvorrichtung für die Sonde umfasst, ist an der Nichtantriebsseite der horizontal- oder vertikalachsigen Maschine angeordnet, umfasst einen Antriebsmotor 51 mit integriertem oder angebautem Drehgeber 52, der eine Stachelwalze 53 antreibt, welche in die Löcher 49a des Lochbandes 49 eingreift. Am Sondensupport 50 sind seitlich zwei Haltestangen 54 angebracht, die an ihren freien Enden Haltemagnete 55 tragen. Der mittlere Abstand der Haltestangen entspricht dem Zweifachen des Abstandes zweier benachbarter Nuten 56 des Stators 14. Die Haltemagnete 55 wirken mit dem Eisenblechen, genauer mit den Statorzähnen 57 des Stators 14 zusammen. Durch diese Befestigungsvariante entfällt eine besondere Befestigung des Sondensupport 50 an der Maschine. Auf der dem Stator 14 zugewandten Fläche der Sonde 1 sind seitlich Permanentmagnete 1a angeordnet, welche mit den Statorzähnen 57 zusammenwirken und eine Führung der Sonde 1 an der Statorbohrungsoberfläche sorgen. Für diese Ausführungsform des Sondensupports bzw. seiner Befestigung an der Maschine wird auch keine Antriebsvorrichtung für die Sonde in Umfangsrichtung benötigt. Zur Fortbewegung der Sonde in Umfangsrichtung wird der Sondensupport 50 von Hand von einer Nut 56 zur nächsten versetzt.

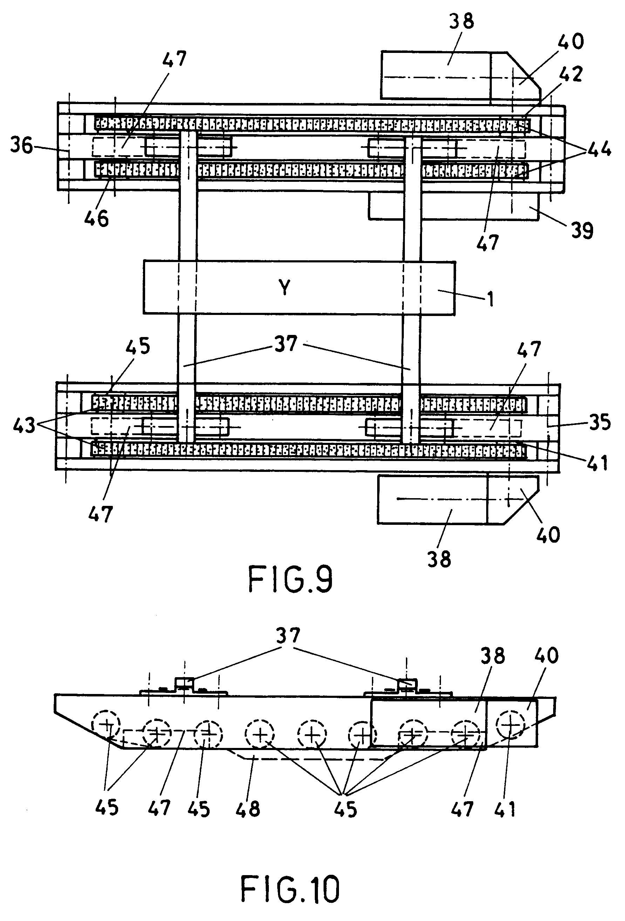

Obwohl sich die im vorstehenden beschriebenen Einrichtungen insbesondere und nicht zuletzt aus Kostengründen für die Erfassung von Teilentladungen bei Maschinen eignen, bei denen der Rotor eingebaut ist, können diese Einrichtungen mit entsprechenden Modifikationen des Trägers oder Halters für die Sondensupporte auch bei Maschinen eingesetzt werden, bei welchen der Rotor aus welchen Gründen auch immer ausgebaut ist. Vorteilhafter - weil mit weniger Aufwand verbunden - ist es jedoch, für dieses Anwendungsgebiet eine Sonde zu verwenden, welche auf einer Selbstfahrlafette mit Eigenantrieb angeordnet ist. Ferngesteuerte Sonden, welche die von ihnen gemessenen Daten (Y-Signal) sowie Informationen über den von der Sonde zurückgelegten Weg (X-Signal) drahtlos oder drahtgebunden an ein entferntes Messgerät übermitteln, sind auf anderen Gebieten der Technik bekannt, z.B. bei der Inspektion von Rohren und Kanälen. Die Anpassung eines solchen Geräts an die vorliegende Aufgabe besteht lediglich darin, dieses Gerät mit der entsprechenden elektrischen Ausrüstung zum Empfang der durch die Teilentladungen initierten AM-Signale zu versehen. Die Draufsicht gemäss Fig.9 sowie die entsprechende Seitenansicht gemäss Fig.10 vermitteln in vereinfachter Darstellung den Aufbau einer Sonde mit Eigenantrieb.

Die Sonde 1 ist ist zwischen zwei Fahrschemeln 35, 36 angeordnet, welche durch Querstreben 37 miteinander verbunden sind. Die Unterseite der Sonde 1 weist eine schlittenartige Kufen 48 (Fig.10) auf, welche die Führung der Sonde längs der Nuten 56 gewährleisten. Jeder Fahrschemel 35, 36 besitzt einen Antriebsmotor 38, welcher über ein Kegelradgetriebe 40 die Treibräder 41, 42 an den Fahrschemeln 35, 36 treibt. Ein am Fahrschemel 36 angebrachter und mit dem Treibrad 42 gekoppelter Drehgeber 39 liefert ein Signal für den Standort der Sonde 1 in der Maschinenlängsachse. Die Treibräder 41, 42 treiben Miniaturraupenketten 43, 44, welche um Rollen 45, 46 geschlungen sind. An jedem Ende der beiden Fahrschemel 35, 36 sind Dauermagnete 47 angeordnet, welche mit dem Eisen des Statorblechpakets zusammenwirken. Diese Magnete 47 ermöglichen es, das Fahrzeug an jedem Punkt des Stators sicher zu halten, ohne seine Fortbewegung unzulässig zu bremsen. Um die Spurweite des Fahrzeugs den unterschiedlichen Nutgeometrien anpassen zu können, werden Querstreben 37 mit verschiedenen Längen und/oder Lochabständen verwendet.

Es versteht sich von selbst, dass eine Sonde gemäss Fig.9 bzw. 10 auch bei elektrischen Maschinen mit eingebautem Rotor eingesetzt werden kann, falls die Grösse des Luftspalts es erlaubt.

## Patentansprüche

1. Einrichtung zur Erfassung von Teilentladungen in Wicklungselementen einer elektrischen Maschine, bei welcher das zu untersuchende Wicklungselement bei angelegter Hochspannung mittels einer auf einem Träger angeordneten fahrbaren Sonde (1) über seine Länge abgetastet und die durch die Teilentladungen initiierten Hochfrequenz-Signale mittels einer Antenne empfangen und in einem nachgeschalteten Messgerät (11) erfasst und ausgewertet werden, dadurch gekennzeichnet, dass der Träger mittels Zugseilen (4,5) oder einer Spindelstange (32) oder eines Zugbandes (49) oder mit Eigenantrieb (38,40,41,43) versehen, ferngesteuert in Maschinenlängsrichtung verfahrbar ist.

2. Einrichtung nach Anspruch 1, dadurch gekennzeichnet, dass die Zugseile (4,5) oder Spindelstange (32) an beiden Rotorseiten an Sondensupporte (6,7) führen, die ihrerseits an einem bezüglich der Rotorachse rotationssmymetrischen Maschinenteil, vorzugsweise dem Maschinenlüfter (16),in Umfangsrichtung verschiebbar befestigt sind.

3. Einrichtung für elektrische Maschinen mit mindestens einem Radiallüfter nach Anspruch 2, dadurch gekennzeichnet, dass einer der Sondensupporte (6) auf dem Aussenumfang des Radiallüfters (16) befestigt und in Umfangsrichtung verschiebbar ist.

4. Einrichtung für elektrische Maschinen mit mindestens einem Axiallüfter nach Anspruch 2, dadurch gekennzeichnet, dass einer der Sondensupporte (6) mittels einer Hilfsvorrichtung (21a,21b) auf dem Aussenumfang oder der Nabe des Axiallüfters befestigt und auf dieser in Umfangsrichtung verschiebbar ist.

5. Einrichtung nach Anspruch 4, dadurch gekennzeichnet, dass die Hilfsvorrichtung im wesentlichen aus einem mehrteiligen Ring (21a,21b) besteht, der am Aussenumfang oder der Nabe des Axiallüfters befestigt ist.

6. Einrichtung nach Anspruch 1, dadurch gekennzeichnet, dass die Sonde (1) mittels eines Lochbandes (49) in Maschinenlängsrichtung bewegbar ist, welches durch einen Antrieb (51,53) auf einem Sondensupport (50) angetrieben ist, wobei der Sondensupport (50) mittels Haltestangen (54) mit Haltemagneten (55) am Stator lösbar befestigt und in Umfangsrichtung bewegbar ist.

7. Einrichtung nach Anspruch 1, dadurch gekennzeichnet, dass die Sonde auf einer Lafette (35,36) angeordnet ist, welche neben dem Eigenantrieb (38,40...) Haltemagnete (47) aufweist, welche mit den Eisenblechen des Statorblechkörpers zusammenwirken.

8. Einrichtung nach einem der Ansprüche 1 bis 7, dadurch gekennzeichnet, dass Mittel (24;39) zur Erfassung und Registrierung des Weges der Sonde (1) in Maschinenlängsrichtung und/oder Mittel (21) zur Erfassung und Registrierung des Weges der Sonde (1) in Umfangsrichtung vorgesehen sind.

9. Einrichtung nach einem der Ansprüche 1 bis 8, dadurch gekennzeichnet, dass die Sonde (1) neben einer Antenne einen Antennensignalverstärker aufweist, dessen Ausgang an das Messgerät (11) angeschlossen ist.

10. Einrichtung nach einem der Ansprüche 1 bis 9, dadurch gekennzeichnet, dass die Sonde (1) neben einer Antenne einen Antennensignalverstärker und einen Demodulator enthält und das demodulierte Antennensignal dem Messgerät (11) zugeführt wird.

## Claims

1. Device for detecting partial discharges in winding elements of an electrical machine, in which device the winding element to be investigated is sampled over its length, with high voltage applied, by means of a drivable probe (1) arranged on a support and the radio frequency signals initiated by the partial discharges are received by means of an antenna and are detected and evaluated in a test set (11) connected downstream, characterized in that the support is conveyable, under remote control, in the machine longitudinal direction, by means of tension cables (4, 5) or an axle rod (32) or a tension strip (49), or is provided with a dedicated drive (38, 40, 41, 43).

2. Device according to Claim 1, characterized in that the tension cables (4, 5) or axle rod (32) lead on both sides of the rotor to probe supports (6, 7) which for their part are mounted, such that they can move in the circumferential direction, on a machine part, preferably the machine fan (16), which is rotationally symmetrical with respect to the rotor axis.

3. Device for electrical machines having at least one radial fan according to Claim 2, characterized in that one of the probe supports (6) is mounted on the external circumference of the radial fan (16) and is movable in the circumferential direction.

4. Device for electrical machines having at least one axial fan according to Claim 2, characterized in that one of the probe supports (6) is mounted by means of an auxiliary device (21a, 21b) on the external circumference of the axial fan (16) or on the hub of the axial fan and is movable thereon in the circumferential direction.

5. Device according to Claim 4, characterized in that the auxiliary device consists essentially of a multi-part ring (21a, 21b) which is mounted on the external circumference or the hub of the axial fan.

6. Device according to Claim 1, characterized in that the probe (1) can be moved in the machine longitudinal direction by means of a perforated strip (49) which is driven by a drive (51, 53) on a probe support (50), the probe support (50) being mounted detachably on the stator by means of retaining rods (54) with retaining magnets (55) and being movable in the circumferential direction.

7. Device according to Claim 1, characterized in that the probe is arranged on a carriage (35, 36) which, as well as the dedicated drive (38, 40...), has retaining magnets (47) which interact with the iron plates of the stator laminated core.

8. Device according to one of Claims 1 to 7, characterized in that means (24; 39) are provided for detecting and recording the movement of the probe (1) in the machine longitudinal direction or means (21) are provided for detecting and recording the movement of the probe (1) in the circumferential direction.

9. Device according to one of Claims 1 to 8, characterized in that, as well as an antenna, the probe (1) has an antenna signal amplifier whose output is connected to the test set (11).

10. Device according to one of Claims 1 to 9, characterized in that, as well as an antenna, the probe (1) contains an antenna signal amplifier and a demodulator and the demodulated antenna signal is supplied to the test set (11).

## Revendications

1. Dispositif pour la détection de décharges partielles dans des éléments d'enroulements d'une machine électrique, dans lequel l'élément d'enroulement à examiner est inspecté sur sa longueur au moyen d'une sonde mobile (1) disposée sur un support, avec la haute tension appliquée, et les signaux à haute fréquence provoqués par les décharges partielles sont captés au moyen d'une antenne et détectés et exploités dans un appareil de mesure (11) qui suit, caractérisé en ce que le support est mobile par télécommande dans le sens longitudinal de la machine, au moyen de câbles de traction (4, 5) ou d'une tige filetée (32) ou d'une bande de traction (49) ou parce qu'il est pourvu de son propre moteur (38, 40, 41, 43).

2. Dispositif suivant la revendication 1, caractérisé en ce que les câbles de traction (4, 5) ou la tige filetée (32) conduisent, de part et d'autre du rotor, à des supports de sonde (6, 7) qui sont, à leur tour, fixés à une partie de la machine qui présente une symétrie de rotation par rapport à l'axe du rotor, de préférence au ventilateur (16) de la machine, tout en étant déplaçables dans le sens périphérique.

3. Dispositif pour des machines électriques avec au moins un ventilateur radial suivant la revendication 2, caractérisé en ce qu'un des supports de sonde (6, 7) est fixé à la périphérie extérieure du ventilateur radial (16) et est déplaçable dans le sens périphérique.

4. Dispositif pour des machines électriques avec au moins un ventilateur axial suivant la revendication 2, caractérisé en ce qu'un des supports de sonde (6, 7) est fixé par un dispositif auxiliaire (26a, 26b) à la périphérie extérieure ou au moyeu du ventilateur axial et est déplaçable sur ce dernier dans le sens périphérique.

5. Dispositif suivant la revendication 4, caractérisé en ce que le dispositif auxiliaire se compose essentiellement d'une bague en plusieurs parties (26a, 26b), qui est fixée à la périphérie extérieure ou au moyeu du ventilateur axial.

6. Dispositif suivant la revendication 1, caractérisé en ce que la sonde (1) est mobile dans le sens longitudinal de la machine au moyen d'une bande perforée (49), qui est entraînée par un moteur (51, 53) sur un support de sonde (50), le support de sonde (50) étant fixé mais démontable sur le stator au moyen de barres de maintien (54) avec des aimants de maintien (55) et étant déplaçable dans le sens périphérique.

7. Dispositif suivant la revendication 1, caractérisé en ce que la sonde est disposée sur un chariot (35, 36) qui, en plus de son propre moteur (38, 40), présente des aimants de maintien (47) qui coopèrent avec les tôles de fer de l'empilement de tôles du stator.

8. Dispositif suivant l'une des revendications 1 à 7, caractérisé en ce qu'il est prévu des moyens (24; 39) pour la détermination et l'enregistrement du chemin parcouru par la sonde (1) dans le sens longitudinal de la machine et/ou des moyens (21) pour la détermination et l'enregistrement du chemin parcouru par la sonde (1) dans le sens périphérique.

9. Dispositif suivant l'une des revendications 1 à 8, caractérisé en ce que la sonde (1) présente, en plus d'une antenne, un amplificateur du signal d'antenne dont la sortie est raccordée à l'appareil de mesure (11).

10. Dispositif suivant l'une des revendications 1 à 9, caractérisé en ce que la sonde (1) comporte, en plus d'une antenne, un amplificateur du signal d'antenne et un démodulateur et en ce que le signal d'antenne démodulé est envoyé à l'appareil de mesure (11).
